# EUROPEAN PATENT APPLICATION

(11) **EP 4 622 423 A1**
(43) Date of publication of application: **24.09.2025**
(21) Application number: 24209779.8
(22) Date of filing: 30.10.2024
(51) Int. Cl.: H10F 77/20, H10F 71/00

(54) **METAL-SEMICONDUCTOR CONTACT STRUCTURE AND PREPARATION METHOD THEREOF, SOLAR CELL AND PHOTOVOLTAIC MODULE**

(30) Priority: 21.03.2024 CN 202410330172
(71) Applicant: Tongwei Solar (Chengdu) Co., Ltd., Chengdu, Sichuan 610299 (CN)
(72) Inventor: CHEN, Yang, Chengdu (CN); FAN, Jianbin, Chengdu (CN); MENG, Xiajie, Chengdu (CN)
(74) Representative: Ran, Handong

(57) **Abstract**

The present application relates to the field of solar cells, and in particular to a metal-semiconductor contact structure and a preparation method thereof, a solar cell and a photovoltaic module. The metal-semiconductor contact structure includes a metal electrode and a semiconductor layer in contact with each other. The metal electrode has a metal element, and the semiconductor layer has a semiconductor element and a doping element for doping the semiconductor layer. A contact interface between the metal electrode and the semiconductor layer has a hole and a conductive structure. The conductive structure includes a conductive eutectic adjacent to the semiconductor layer, and a conductive crystal extending from the conductive eutectic into the hole. The conductive eutectic includes a eutectic formed by the metal element and the semiconductor element, and the conductive crystal includes a crystal formed by crystallization of the metal element. The metal-semiconductor contact structure can improve a contact performance of the metal-semiconductor contact structure, and further promote the improvement of performance indexes such as open circuit voltage and photoelectric conversion efficiency of a solar cell.

## Description

### TECHNICAL FIELD

The present application relates to the field of solar cells, and in particular to a metal-semiconductor contact structure and a preparation method thereof, a solar cell and a photovoltaic module.

### BACKGROUND

Metal-semiconductor contact structure is an important component structure of a solar cell, which has an important influence on the performance of the solar cell. Generally, a metal-semiconductor contact structure can be formed by printing and sintering a paste containing a metal material, but this practice at present leads to a problem that the contact resistance of the conductive contact region between the metal material and the semiconductor material is large, the contact performance needs to be optimized urgently, and thus further improvement in the performance such as the open circuit voltage and the photoelectric conversion efficiency of the solar cell is affected.

### SUMMARY

In order to solve the above-mentioned technical problem, the present application discloses a metal-semiconductor contact structure and a preparation method, a solar cell and a photovoltaic module, which can effectively improve a contact performance of the metal-semiconductor contact structure and optimize performances of the solar cell.

In a first aspect, the present application provides a metal-semiconductor contact structure including a metal electrode and a semiconductor layer in contact with each other, wherein the metal electrode has a metal element, and the semiconductor layer has a semiconductor element and a doping element for doping the semiconductor layer;

a contact interface between the metal electrode and the semiconductor layer has a hole and a conductive structure, the conductive structure includes a conductive eutectic adjacent to the semiconductor layer, and a conductive crystal extending from the conductive eutectic into the hole, the conductive eutectic includes a eutectic formed by the metal element and the semiconductor element, the conductive crystal includes a crystal formed by crystallization of the metal element.

Further, the metal electrode includes a silver electrode; and/or,
the semiconductor element includes a silicon element; and/or,
the semiconductor layer includes a doped silicon layer or an intrinsic silicon layer, wherein the doped silicon layer includes one of a doped amorphous silicon layer, a doped polysilicon layer or a diffusion doped crystalline silicon layer, and the intrinsic silicon layer includes an intrinsic amorphous silicon layer, a hydrogenated amorphous silicon layer or an intrinsic polysilicon layer.

Further, the doped silicon layer includes one of a doped amorphous silicon layer, a doped polysilicon layer, a doped microcrystalline silicon layer or a doped crystalline silicon layer; wherein the doped crystalline silicon layer is prepared by thermally diffusing the doping element on crystalline silicon;
the semiconductor layer includes an intrinsic silicon layer, and the intrinsic silicon layer includes an intrinsic amorphous silicon layer, a hydrogenated amorphous silicon layer or an intrinsic polysilicon layer.

Further, the metal-semiconductor contact structure has a first conductive region and a second conductive region outside the first conductive region. The first conductive region has the hole and the conductive structure, and the second conductive region has a glass frit and metal particles. The glass frit is in contact with the semiconductor layer and ablates a portion of a passivation layer on the semiconductor layer. Wherein the metal particles form a direct conductive contact with the semiconductor layer through the portion of the passivation layer that is ablated; and the metal particles and the conductive crystal have a same kind of the metal element.

Further, the conductive crystal is contained within the hole.

Further, the conductive crystal includes a crystalline main chain and a crystalline side chain extending from the crystalline main chain toward a direction different from a growth direction of the crystalline main chain.

Further, a density of the hole is greater than or equal to 10/mm² and less than 100/mm²;
and/or, a hole diameter of the hole is 100 nm to 2000 nm;
and/or, a size of the conductive crystal is 10 nm to 100 nm.

Further, the metal electrode is a silver electrode, and a aluminum impurity content in the silver electrode is less than 0.1 wt%.

In a second aspect, embodiments of the present application provide a preparation method of the metal-semiconductor contact structure according to the first aspect, wherein the method includes the following steps:
printing an electrode paste on the semiconductor layer; the electrode paste includes a glass frit, metal particles, and an organic carrier;
low-temperature sintering the electrode paste to form an electrode precursor on the semiconductor layer, the electrode precursor including a glass frit and metal particles wrapped in the glass frit; a sintering temperature of the low-temperature sintering is less than a peak sintering temperature of the electrode paste;
applying a reverse bias voltage to the electrode precursor and simultaneously performing laser-induced contact treatment to form the metal electrode, and forming the hole and the conductive structure in a contact interface region between the metal electrode and the semiconductor layer.

Further, in the step of low-temperature sintering the electrode paste, a sintering temperature is 500°C to 650°C.

Further, in the step of applying a reverse bias voltage to the electrode precursor and simultaneously performing the laser-induced contact treatment, a voltage of the reverse bias voltage is 9 V to 15 V

Further, in the step of applying a reverse bias voltage to the electrode precursor and simultaneously performing the laser-induced contact treatment, a voltage of the reverse bias voltage is 11 V to 15 V

Further, in the step of applying a reverse bias voltage to the electrode precursor and simultaneously performing the laser-induced contact treatment, conditions of the laser-induced contact treatment include a wavelength of 500 nm to 1100 nm, a current density of 1000A/cm² to 1400A/cm², and a scanning rate of 35 m/s to 55 m/s.

Further, the preparation method further includes: performing light injection after the step of low-temperature sintering the electrode paste and before the step of applying a reverse bias voltage to the electrode precursor and simultaneously performing laser-induced contact treatment;
or, the preparation method further includes: performing light injection after the step of applying a reverse bias voltage to the electrode precursor and simultaneously performing laser-induced contact treatment.

Further, the step of light injection includes:
primarily heating of the electrode precursor, wherein a peak temperature of the primary heating is 200°C to 600°C;
secondary heating of the electrode precursor and illumination, wherein a peak temperature of the secondary heating is 100°C to 300°C, an energy density of the illumination is 10 kW/m² to 100 kW/m², and a wavelength of the illumination is a continuous spectral band of 500 nm to 1100 nm.

In a third aspect, the present application provides a solar cell including the metal-semiconductor contact structure according to the first aspect, or including the metal-semiconductor contact structure prepared by the preparation method according to the second aspect.

Further, the solar cell further includes:
a silicon substrate having a light-receiving surface with a textured surface structure;
wherein the metal-semiconductor contact structure is provided on a light-receiving surface and/or a backlight surface of the silicon substrate, the semiconductor layer of the metal-semiconductor contact structure is provided close to the silicon substrate, and the semiconductor layer also has the textured surface structure.

Further, the textured surface structure is a pyramid structure, and the hole in the metal-semiconductor contact structure is located at and near a spire of the pyramid structure.

Further, the solar cell further includes a passivation layer provided on a surface of the semiconductor layer facing away from the silicon substrate, and the metal electrode penetrates the passivation layer and is in contact with the semiconductor layer.

Further, the solar cell includes a PERC cell, an HJT cell, a TOPCon cell, an IBC cell, or a perovskite-crystalline silicon stack solar cell.

As one implementation, the solar cell is a TOPCon cell, and the solar cell includes:
the silicon substrate;
a PN junction region, a first passivation layer, and a first metal electrode sequentially provided on a light-receiving surface of the silicon substrate in a direction away from the light-receiving surface, wherein the PN junction region is a first semiconductor layer;
a passivation contact structure, a second passivation layer and a second metal electrode sequentially provided on a backlight surface of the silicon substrate in a direction away from the backlight surface, wherein the passivation contact structure includes a tunneling passivation layer provided close to the silicon substrate and a doped silicon layer provided away from the silicon substrate, the doped silicon layer has a same conductivity type as the silicon substrate, and the doped silicon layer is a second semiconductor layer;
the first metal electrode penetrates the first passivation layer into contact with the PN junction region so that the PN junction region and the first metal electrode form the metal-semiconductor contact structure, and/or, the second metal electrode penetrates the second passivation layer into contact with the doped silicon layer so that the doped silicon layer and the second metal electrode form the metal-semiconductor contact structure.

Further, the first semiconductor layer is formed by performing thermal diffusion of the doping element to the silicon substrate, or the first semiconductor layer is a doped polysilicon layer or a doped amorphous silicon layer deposited on the light-receiving surface of the silicon substrate; and/or,
the first passivation layer is one or more of an aluminum oxide layer, a silicon oxide layer, a silicon oxynitride layer, and a silicon nitride layer deposited on the PN junction region; and/or,
the tunneling passivation layer is at least one of a silicon oxide layer, an amorphous silicon layer, a polycrystalline silicon layer, and a silicon carbide layer; and/or,
the second passivation layer is one or more of a silicon oxide layer, a silicon oxynitride layer, and a silicon nitride layer deposited on the second semiconductor layer.

As one implementation, the solar cell is an HJT cell, and the solar cell includes:
a silicon substrate;
a first intrinsic layer, a first semiconductor layer, a first transparent conductive layer sequentially provided on a light-receiving surface of the silicon substrate, and a first metal electrode disposed on the light-receiving surface of the silicon substrate;
a second intrinsic layer, a second semiconductor layer, a second transparent conductive layer sequentially provided on a backlight surface of the silicon substrate, and a second metal electrode disposed on the backlight surface of the silicon substrate;
wherein, the first metal electrode and the first semiconductor layer, the first transparent conductive layer form the metal-semiconductor contact structure, and/or the second metal electrode and the second semiconductor layer, the second transparent conductive layer form the metal-semiconductor contact structure.

Further, the first intrinsic layer includes one or more of an intrinsic amorphous silicon layer, and a hydrogenated amorphous silicon layer; and/or,
the first semiconductor layer is one or more doped silicon layers; and/or,
the first transparent conductive layer is one or more of an indium tin oxide layer, an aluminum-doped zinc oxide layer, a zinc oxide layer, an indium oxide layer, and a tin oxide layer; and/or,
the second intrinsic layer includes one or more of an intrinsic amorphous silicon layer, and a hydrogenated amorphous silicon layer; and/or,
the second semiconductor layer is one or more doped silicon layers; and/or,
the second transparent conductive layer is one or more of an indium tin oxide layer, an aluminum-doped zinc oxide layer, a zinc oxide layer, an indium oxide layer, and a tin oxide layer.

As one implementation, the solar cell is an PERC solar cell, and the solar cell includes:
a silicon substrate;
a first semiconductor layer and a first passivation layer sequentially formed on a light-receiving surface of the silicon substrate;
a first metal electrode penetrating the first passivation layer and forming the metal-semiconductor contact structure with the first semiconductor layer.

Further, the first semiconductor layer is one or more doped silicon layers; and/or,
the solar cell further includes a second semiconductor layer and a backside field passivation layer sequentially provided on a backlight surface of the silicon substrate, and a second metal electrode is further provided on a side of the backlight surface of the silicon substrate, and the second metal electrode is in ohmic contact with the second semiconductor layer.

As one implementation, the solar cell is an IBC solar cell, and the solar cell includes:
a silicon substrate;
a tunneling passivation layer, a first semiconductor layer, a first passivation layer, and a first metal electrode sequentially provided on an N-type conductive region of a backlight surface of the silicon substrate;
the tunneling passivation layer, a second semiconductor layer, a second passivation layer, and a second metal electrode sequentially provided on a P-type conductive region of the backlight surface of the silicon substrate; one layer of the first semiconductor layer and the second semiconductor layer has an N-type doping element and the other layer has a P-type doping element;
wherein the first metal electrode penetrates the first passivation layer and contacts the first semiconductor layer, so that the first metal electrode and the first semiconductor layer form the metal-semiconductor contact structure, and/or, the second metal electrode penetrates the second passivation layer and contacts the second semiconductor layer, so that the second metal electrode and the second semiconductor layer form the metal-semiconductor contact structure.

In a fourth aspect, the present application provides a photovoltaic module including the solar cell according the third aspect.

Compared with the prior art, the present application has at least the following beneficial effects:
The present application provides a novel metal-semiconductor contact structure, which can effectively improve a transportation capacity of carriers from a semiconductor layer to a metal-semiconductor contact region and from the metal-semiconductor contact region to a metal electrode, improve a contact performance of the metal-semiconductor contact structure, and further promote the improvement of performance indexes such as open circuit voltage and photoelectric conversion efficiency of a solar cell.

In the above structure, the conductive structure includes both a conductive eutectic close to the semiconductor layer at the contact interface and a conductive crystal growing and extending from the conductive eutectic toward the hole. Since the conductive eutectic includes an eutectic formed of a metal element and a semiconductor element, it is not only beneficial for carriers to be transported from the substrate to the semiconductor layer of the solar cell, but also has lower contact resistivity than the non-eutectic state of the metal nanoparticle and the semiconductor material, that is, the conductive eutectic has lower contact resistivity, which is beneficial for optimizing the contact performance between the metal electrode and the semiconductor layer.

At the same time, the conductive crystal grown from the conductive eutectic towards the hole includes a crystal formed by crystallization of the metal element. Compared with the structure in which metal nanoparticles are in contact with semiconductor materials, the conductive crystals formed by crystallization of this metal element have higher purity elemental characteristics, and then have lower resistivity and better carrier transport ability. Having this conductive crystal in the hole can further reduce the loss of carrier during transportation from the conductive eutectic to the metal electrode on the basis of reducing the contact resistance between the metal electrode and the semiconductor layer by the conductive eutectic, thereby optimizing the contact performance between the metal electrode and the semiconductor layer through mutual cooperation of the conductive eutectic and the conductive crystal located in the hole, and further improving the performance indexes such as open circuit voltage and photoelectric conversion efficiency of the solar cell.

### BRIEF DESCRIPTION OF THE DRAWINGS

To describe the technical solutions in embodiments of the present application more clearly, the following briefly describes the accompanying drawings for the embodiments. It is clear that the accompanying drawings in the following description show merely some embodiments of the present application, and a person of ordinary skill in the art may derive other drawings from these accompanying drawings without creative efforts.
FIG. 1 is a schematic structural diagram of a first solar cell according to an embodiment of the present application.
FIG. 2 is an enlarged schematic view of a structure at A in FIG. 1;
FIG. 3 is a schematic structural diagram of a first conductive region in a metal-semiconductor contact structure according to an embodiment of the present application;
FIG. 4 is a schematic structural diagram of a second solar cell according to an embodiment of the present application;
FIG. 5 is a schematic structural diagram of a third solar cell according to an embodiment of the present application;
FIG. 6 is a schematic structural diagram of a fourth solar cell according to an embodiment of the present application;
FIG. 7 is a SEM diagram at a contact interface of a metal-semiconductor contact structure in a solar cell according to Embodiment 1 of the present application;
FIG. 8 is another SEM diagram at the contact interface of the metal-semiconductor contact structure in the solar cell according to Embodiment 1 of the present application.

### Description of the reference numerals:

100, Silicon substrate; 200, Semiconductor layer; 201, First semiconductor layer; 202, Second semiconductor layer; 300, Metal electrode; 301, First metal electrode; 302, Second metal electrode; 400, Passivation layer; 401, First passivation layer ; 4011, Alumina passivation layer; 4012, Anti-reflection layer; 402, Second passivation layer; 403, Third passivation layer; 500, Tunneling passivation layer; 601, First intrinsic layer; 602, Second intrinsic layer; 701, First transparent conductive layer; 702, Second transparent conductive layer; 800, Backside field passivation layer;
1, Metal-semiconductor contact structure; 11, Hole; 12, Conductive structure; 121, Conductive eutectic; 122, Conductive crystal; 1221, Crystalline main chain; 1222, Crystalline side chain; 13, Contact interface; 14, glass frit; 15, Metal particle; 1a, First conductive region ;1b, Second conductive region 1b.

### DETAILED DESCRIPTION

The following clearly describes the technical solutions in embodiments of the present application with reference to the accompanying drawings in embodiments of the present application. It is clear that the described embodiments are some but not all of embodiments of the present application. All other embodiments obtained by a person of ordinary skill in the art based on embodiments of the present application without creative efforts shall fall within the protection scope of this application.

In the present application, the orientation or positional relationship indicated by the terms "on", "under", "left", "right", "front", "back", "top", "bottom", "inside", "outside", "vertical", "horizontal", "transverse", "longitudinal" and the like is based on the orientation or positional relationship shown in the drawings. These terms are mainly intended to better describe the present application and its embodiments and are not intended to limit that the indicated devices, elements or constituents must have a particular orientation, or be constructed and operated in a particular orientation.

Also, in addition to being used to represent an orientation or positional relationship, some of the above terms may also be used to indicate other meanings. For example, the term "on" may also be used in some cases to denote a certain attachment or connection. The specific meanings of these terms in the present application may be understood by those ordinarily skilled in the art as the case may be.

In addition, the terms "installation", "setting", "being provided with", "connecting", "connected", "sleeving" should be understood broadly. For example, the connection may be a fixed connection, a detachable connection or an integrated construction, or may be a mechanical connection or an electrical connection, or may be a direct connection, or may be an indirect connection through an intermediary, or an internal communication between two devices, elements or constituents. The specific meanings of the above terms in the present application may be understood by those ordinarily skilled in the art as the case may be.

In addition, the terms "first", "second", etc., are used primarily to distinguish different devices, elements or components (the specific type and construction may be the same or different) and are not used to indicate or imply the relative importance or quantity of the indicated device, element or component. Unless otherwise stated, "plurality" means two or more.

In solar cells, a contact performance of metal-semiconductor contact structure may have an important impact on photoelectric conversion efficiency and other properties of solar cells. The metal-semiconductor contact structure is a structure formed by contacting a metal electrode with a conductive semiconductor layer having a conductive function. The semiconductor layer is used to transport photogenerated carriers out of the substrate (such as a silicon substrate), and the metal electrode is used to collect carriers, and then collect the collected carriers through a bus ribbon. The contact performance between the semiconductor layer and the metal electrode directly affects the transmission capacity of the carriers between the semiconductor layer and the metal electrode, and then affects the photoelectric conversion efficiency and other performance indexes of the solar cell.

A method of preparing a metal-semiconductor contact structure is that electrode paste is screen printed on a surface of a passivation layer provided on a semiconductor layer, and then the electrode paste is sintered at high temperature (generally a peak sintering temperature is 750°C to 850°C), so that the electrode paste burns through the passivation layer and contacts with the semiconductor layer to form a patterned metal electrode, thus realizing the metal-semiconductor contact structure. In the above method, main components of the electrode paste include glass frit, metal powder (such as silver powder), organic carrier, and the like. Among them, the metal powder is mainly used to transport carriers. The organic carrier mainly plays the role of dispersing the metal powder, so that the metal powder can be fully mixed in the glass frit, and the metal powder can be dispersed in the organic solvent, and can be fixed on the semiconductor layer by screen printing in the form of a paste. Glass frit mainly plays a corrosive role at high temperature, burns through the passivation layer and brings part of the metal powder to the surface of the semiconductor layer, and conductivity is achieved through the contact between the metal and the silicon of the semiconductor layer.

However, excessively high temperature glass powder not only promotes the conductive contact between the metal electrode and the semiconductor layer, but also causes irreversible large-area corrosion on the contact interface of the metal-semiconductor contact structure, resulting in more corrosion structural defects in the contact interface, destroying the passivation film structure on the surface of the semiconductor layer, and then causing the carrier recombination rate at the contact interface to increase, greatly reducing the open circuit voltage and series resistance of the solar cell, and then reducing the photoelectric conversion efficiency of the solar cell. In addition, the metal-semiconductor contact structure obtained by the above method may also increase the contact resistivity between the metal and the semiconductor layer because the glass frit component burned through the passivation film layer is a high-resistivity medium, thereby weakening the carrier transport capacity at the metal-semiconductor contact structure. To sum up, it can be seen that the contact performance of the metal-semiconductor contact structure still needs to be further optimized to improve the photoelectric conversion efficiency and other indexes of solar cells.

Based on the discovery and analysis of the above problems, the present application proposes a new metal-semiconductor contact structure and a preparation method thereof, a solar cell, and a photovoltaic module, which optimize the contact performance of the metal-semiconductor contact structure by solving the problems of irreversible large-area corrosion and low carrier transport capacity of the metal-semiconductor contact structure, thereby improving electrical performance indexes such as photoelectric conversion efficiency of the solar cell.

Since the metal-semiconductor contact structure of the embodiments of the present application is applied to a solar cell (especially to a crystalline silicon solar cell), the metal-semiconductor contact structure and the preparation method thereof will be introduced below when the solar cell of the embodiments of the present application is introduced, and the metal-semiconductor contact structure and the preparation method thereof will not be described separately.

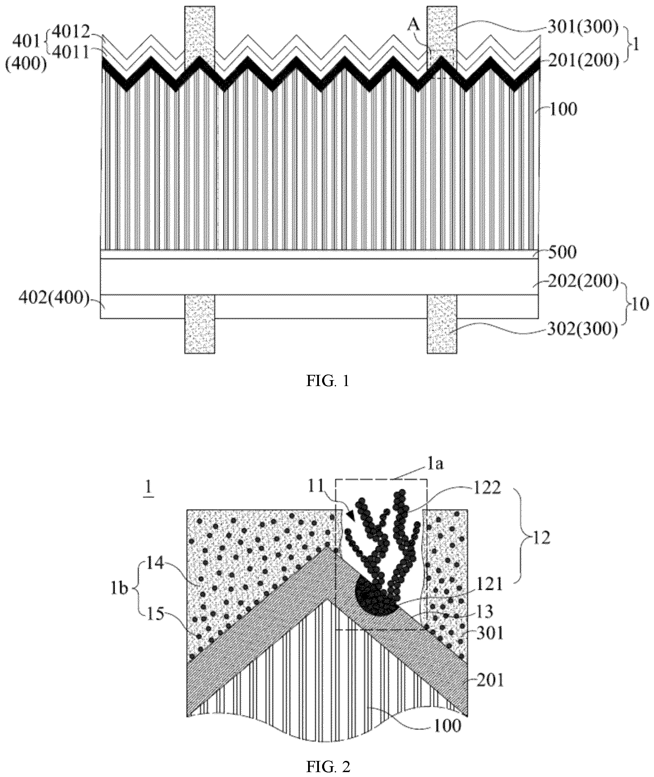

In a first aspect, the embodiments of the present application provide a solar cell having a metal-semiconductor contact structure. Referring to FIG. 1, FIG. 1 is a schematic structural diagram of a first solar cell according to an embodiment of the present application, and the solar cell includes:
a silicon substrate 100;
a semiconductor layer 200 and a passivation layer 400 sequentially provided on a surface of the silicon substrate 100;
a metal electrode 300 penetrating the passivation layer 400 and in physical contact with the semiconductor layer 200.

That is, the metal electrode 300 and the semiconductor layer 200 in physical contact form the metal-semiconductor contact structure 1. Among them, physical contact refers to direct contact between a structure of the metal electrode and a structure of the semiconductor layer.

Here, the semiconductor layer 200 may be provided on a light-receiving surface and/or a backlight surface of the silicon substrate 100, and correspondingly, the metal-semiconductor contact structure 1 may also be provided on the light-receiving surface and/or the backlight surface of the silicon substrate 100. As shown in FIG. 1, the semiconductor layer 200 includes a first semiconductor layer 201 provided on the light-receiving surface of the silicon substrate 100 and a second semiconductor layer 202 provided on the backlight surface of the silicon substrate 100. The passivation layer 400 includes a first passivation layer 401 provided on a surface of the first semiconductor layer 201 facing away from the silicon substrate 100, and a second passivation layer 402 provided on a surface of the second semiconductor layer 202 facing away from the silicon substrate 100. The metal electrode 300 includes a first metal electrode 301 in contact with the first semiconductor layer 201, and a second metal electrode 302 in contact with the second semiconductor layer 202. The first semiconductor layer 201 is in contact with the first metal electrode 301 to form the metal-semiconductor contact structure 1 located on the light-receiving surface of the silicon substrate 100. The second semiconductor layer 202 is in contact with the second metal electrode 302 to form the metal-semiconductor contact structure 1 located on the backlight surface of the silicon substrate 100.

Taking the metal-semiconductor contact structure 1 located on the light-receiving surface of the silicon substrate 100 as an example, the metal-semiconductor contact structure 1 of the embodiments of the present application will be further described below.

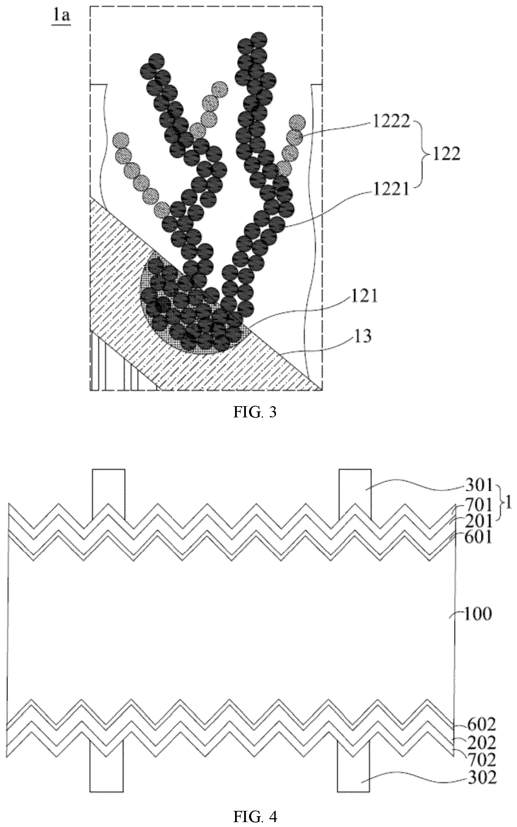

Referring to FIG. 2 and FIG. 3, FIG. 2 is an enlarged schematic diagram of a structure at A in FIG. 1, and is also a schematic structural diagram of the metal-semiconductor contact structure 1 according to an embodiment of the present application, and FIG. 3 is a schematic structural diagram of a first conductive region in the metal-semiconductor contact structure according to an embodiment of the present application. In the metal-semiconductor contact structure 1, the first metal electrode 301 has a metal element, and the first semiconductor layer 201 has a semiconductor element and a doping element for doping the semiconductor layer. A hole 11 and a conductive structure 12 are provided at a contact interface 13 between the first metal electrode 301 and the first semiconductor layer 201, and the conductive structure 12 includes a conductive eutectic 121 close to the first semiconductor layer 201, and a conductive crystal 122 extending from the conductive eutectic 121 toward the hole 11. The conductive eutectic 121 includes a eutectic formed of a metal element and a semiconductor element, and the conductive crystal 122 includes a crystal formed by crystallization of the metal element.

Here, the fact that the first metal electrode 301 has a metal element means that a material corresponding to the metal element is used as a main component in the first metal electrode 301, and for example, when the first metal electrode 301 is a silver electrode, the main component in the first metal electrode 301 is a silver element. However, since the first metal electrode 301 is usually produced by screen printing and processing of an electrode paste, and the electrode paste includes glass frit and an organic carrier in addition to metal powder, the finally produced first metal electrode 301 may include other components that are not completely decomposed in the electrode paste in addition to metal elements as the main components. Further, when the metal electrode is a silver electrode, a content of a metallic aluminum impurity in the silver electrode is less than 0.1 wt%.

The fact that the first semiconductor layer 201 has a semiconductor element and a doping element for doping the semiconductor layer means that a material corresponding to the semiconductor element is a main component in the first semiconductor layer 201. For example, when the semiconductor element is a silicon element and the first semiconductor layer 201 is a PN junction region, the main component in the first semiconductor layer 201 is a silicon film layer corresponding to the silicon element. The PN junction region may be a diffused silicon layer formed by diffusing and doping a doping element different from that of the silicon substrate 100 into the silicon substrate 100, or a crystalline silicon layer doped with the doping element formed on the silicon substrate 100 by in-situ doping. The doping element is, for example, a phosphorus element or a boron element, which means that a certain concentration of the doping element may be further doped when the main component is a silicon layer.

Optionally, the first metal electrode 301 includes one or more kinds of silver electrodes. Optionally, the first semiconductor layer 301 includes a doped silicon layer or an intrinsic silicon layer, wherein the doped silicon layer includes one of a doped amorphous silicon layer, a doped polysilicon layer or a crystalline silicon layer doped by thermal diffusion, and the intrinsic silicon layer includes an intrinsic amorphous silicon layer, a hydrogenated amorphous silicon layer or an intrinsic polysilicon layer. For example, in a passivated contact solar cell, the first semiconductor layer 201 may be a doped silicon layer, such as a doped amorphous silicon layer or a PN junction region (the PN junction region may be a diffused silicon layer formed on the silicon substrate 100 by high temperature diffusion). Optionally, a silicon element may be used as the semiconductor element in the first semiconductor layer 201. For example, the silicon substrate 100 is an N-type silicon substrate 100, the first metal electrode 301 is a silver electrode, and the first semiconductor layer 201 is a PN junction region formed by boron diffusing into the N-type silicon substrate 100. The above metal-semiconductor contact structure 1 is a contact structure of the silver electrode and the PN junction. In the conductive structure 12 at the contact interface 13, the conductive eutectic 121 is a eutectic structure formed by the silver element and the silicon element, and the conductive crystal 122 is a crystal formed by crystallization of the silver element, that is, a silver elemental substance in a crystal form.

The term "intrinsic" of "the intrinsic silicon layer" means that a doping concentration of the doping element in silicon is less than 10¹⁰/cm³.

In the metal-semiconductor contact structure 1, by forming the hole 11 and the specific conductive structure 12 at the interface where the first metal electrode 301 and the first semiconductor layer 201 are in contact, the contact resistance between the first metal electrode 301 and the semiconductor can be reduced, the carrier transport capacity can be improved, and both the open circuit voltage and the photoelectric conversion efficiency of the solar cell can be improved.

In the above structure, the conductive structure 12 includes both the conductive eutectic 121 close to the first semiconductor layer 201 at the contact interface 13 and the conductive crystal 122 growing and extending from the conductive eutectic 121 toward the hole 11. Since the conductive eutectic 121 includes the eutectic formed of the metal element and the semiconductor element, it is not only beneficial for carriers to be transported from the substrate to the first semiconductor layer 201 of the solar cell, but also has lower contact resistivity than the non-eutectic state of the metal nanoparticle and the semiconductor material. Among them, there are at least two carrier transport paths for photogenerated carriers in an interface region of the metal-semiconductor contact structure. And a first carrier transport paths is: the silicon substrate 100, the semiconductor layer 200, the conductive eutectic 121, and the conductive crystal 122; and a second carrier transport path is: the silicon substrate 100, the semiconductor layer 200, and the glass frit 14 containing the metal particles 15. It can be seen that the first carrier transport path has a lower resistivity, which is beneficial to optimize the contact performance between the first metal electrode 301 and the first semiconductor layer 201. For example, when the metal electrode is a silver electrode and the semiconductor layer is a doped silicon layer, since the conductive eutectic is a eutectic formed of a silver element and a silicon element, it has lower resistivity and better conductivity than the direct contact (that is, a non-eutectic contact) between the nano-silver powder and the silicon layer.

At the same time, the conductive crystal 122 grown from the conductive eutectic 121 towards the hole 11 includes a crystal formed by crystallization of the metal element. Compared with the structure in which the metal particle is in contact with the semiconductor material, the conductive crystal 122 formed by crystallization of this metal element has a higher characteristic, and has lower resistivity and better carrier transport ability. Having this high-purity conductive crystal 122 in the hole 11 can further reduce the loss of carrier during transportation from the conductive eutectic 121 to the first metal electrode 301 on the basis of reducing the contact resistance between the first metal electrode 301 and the first semiconductor layer 201 by the conductive eutectic 121, thereby optimizing the contact performance between the first metal electrode 301 and first the semiconductor layer 201 through mutual cooperation of the conductive eutectic 121 and the conductive crystal 122 located in the hole 11, and further improving open circuit voltage, reducing series resistance and improving the performance indexes such as photoelectric conversion efficiency of the solar cell.

Further, in the metal-semiconductor contact structure 1 according to the embodiments of the present application, the density of the hole 11 is greater than or equal to 10/mm² and less than 100/mm², and a hole diameter of the holes 11 is 100 nm to 2000 nm. When the density and hole diameter of the hole 11 are controlled within the above range, the conductive structure 12 having a suitable number distribution density can be provided, and the conductive eutectic 121 and the conductive crystal 122 in the conductive structure 12 can work together to improve the carrier transportation capacity and reduce the contact resistance. At the same time, a degree of structural damage caused by the existence of the hole 11 structure to the contact interface can be reduced, and a carrier recombination rate in the contact interface region can be reduced. It should be noted that although the hole 11 of the embodiments of the present application still inevitably causes certain damage to the contact interface 13 between the first metal electrode and the first semiconductor layer, a damage region of the hole 11 to the structure is obviously much smaller than that of the corrosion of the glass frit 14 causing large-area structural corrosion defects to the contact interface. Therefore, in the embodiments of the present application, by providing the hole 11 and the conductive structure 12 at the contact interface, not only the carrier transport capacity may be optimized by utilizing the conductive eutectic 121 and the conductive crystal 122 in the conductive structure 12, but also a contact recombination phenomenon caused by the large-area corrosion of the contact interface by the glass frit 14 may be reduced by utilizing a small-region damage to the contact interface by the hole 11. The above effects can be further optimized by further optimizing and controlling the density and hole diameter of the hole 11.

Here, positions of the holes 11 on the first semiconductor layer 201 show an irregular random distribution. In the SEM diagram of the metal-semiconductor contact structure 1 having the holes 11, the density of the holes 11 can be calculated to be greater than or equal to 10/mm² and less than 100/mm² from a quantity of holes 11 and an region of the holes 11 within a specified range. By measuring a size of the holes 11, it is possible to determine that the hole diameter of the holes 11 is in the range of 100 nm to 2000 nm. Exemplarily, the density of the holes 11 is 10/mm², 15/mm², 18/mm², 20/mm², 25/mm², 30/mm², 40/mm², 50/mm², 60/mm², 70/mm², 80/mm², 90/mm², or 100/mm². Exemplarily, the hole diameter of the hole 11 is 100 nm, 150 nm, 200 nm, 250 nm, 300 nm, 350 nm, 400 nm, 500 nm, 600 nm, 700 nm, 800 nm, 900 nm, 1000 nm, 1150 nm, 1200 nm, 1250 nm, 1300 nm, 1350 nm, 1400 nm, 1500 nm, 1600 nm, 1700 nm, 1800 nm, 1900 nm or 2000 nm.

Here, the hole diameter of the hole 11 is defined as: the hole is not limited to a circular shape in the geometric sense, and when the hole is a circular shape in the non-geometric sense, the hole is defined as a maximum length in a horizontal direction in the SEM diagram.

Further, in the metal-semiconductor contact structure 1 of the embodiments of the present application, a size of the conductive crystal 122 is 10 nm to 100 nm. The conductive crystal 122 having the above-described length range can be grown in the hole 11 with good crystal quality, and the carrier transport ability can be improved by a high-purity metal element crystal. Among them, the size of the conductive crystal 122 can be obtained by measuring in the SEM diagram of the metal-semiconductor contact structure 1 having the hole 11 and the conductive structure 12, and the size of the conductive crystal 122 refers to a maximum length dimension of the conductive crystal 122 measured in the SEM diagram along a direction perpendicular to a thickness of the first semiconductor layer 201 (that is, the horizontal direction in the SEM diagram). Exemplarily, the size of the conductive crystal 122 is 10 nm, 20 nm, 25 nm, 30 nm, 35 nm, 40 nm, 45 nm, 50 nm, 55 nm, 60 nm, 65 nm, 70 nm, 75 nm, 80 nm, 85 nm, 90 nm, 95 nm or 100 nm.

Further, as shown in FIG. 3, in the metal-semiconductor contact structure 1 of the embodiment of the present application, the conductive crystal 122 includes a crystal main chain 1221 and a crystal side chain 1222 extending from the crystal main chain 1221 in a growth direction different from that of the crystal main chain 1221. In the embodiment of the present application, the crystal main chain 1221 and the side chain laterally grown from the crystal main chain 1221 make the conductive crystal 122 have a branch-like structure as a whole. The branch-shaped conductive crystal 122 can provide more transport channels for carriers from the first semiconductor layer 201 than the conductive crystal 122 grown only in a single direction (for example, a rod-shaped conductive crystal 122), and the branch-shaped conductive crystal 122 has a more divergent structural morphology, which is advantageous to increase a contact probability between the conductive crystal 122 and other conductive materials (such as metal particles 15 from the electrode paste) around the hole 11, and comprehensively improve the carrier transport ability of the conductive crystal 122 in various aspects.

Continuing with reference to FIG. 2 and FIG. 3, the metal-semiconductor contact structure 1 of the embodiments of the present application has a first conductive region 1a and a second conductive region 1b located outside the first conductive region 1a. The first conductive region 1a has the hole 11 and the conductive structure 12 described above, and is a main conductive region of the metal-semiconductor contact structure 1. The second conductive region 1b has glass frit 14 and metal particles 15. The glass frit 14 is in contact with the first semiconductor layer 201 and does not corrode the first semiconductor layer 201, and a portion of the metal particles 15 are in direct contact with the first semiconductor layer 201. In addition, the metal particles 15 and the conductive crystal 122 in the first conductive region 1a have a same metal element. The second conductive region 1b is a secondary conductive region of the metal-semiconductor contact structure 1. In the second conductive region 1b, the glass frit 14 is in contact with the first semiconductor layer 201 but does not corrode the first semiconductor layer 201. It is possible to ensure that the glass frit 14 can not corrode a large area of the first semiconductor layer 201 or cannot corrode the first semiconductor layer 201 by lowering a sintering temperature of the glass frit 14 or the like.

Compared with the first conductive region 1a, the second conductive region 1b has the following differences. Firstly, although the metal particles 15 of the second conductive region 1b and the conductive crystal 122 of the first conductive region 1a have the same metal element, the metal particles 15 are a simple substance formed of a conventional metal element (for example, when the metal element is silver element, the metal particles 15 are nano-silver particles or agglomerated silver particles after agglomeration of nano-silver particles), which have low resistivity and good carrier transport ability. However, since the conductive crystal 122 is obtained by crystallization (for example, when the metal element is silver element, the conductive crystal 122 is silver crystal), the conductive crystal 122 has higher purity, stronger carrier transport ability, and lower resistance than the metal particles 15 formed of the same metal element. Secondly, the metal particles 15 in the second conductive region 1b are dispersed in the glass frit 14 having a higher resistivity, and part of the metal particles 15 that can come into contact with the first semiconductor layer 201 are also sparsely dispersed on the first semiconductor layer 201. The conductive eutectic 121 in the first conductive region 1a is a eutectic formed by co-crystallization of the metal element and the semiconductor element. As can be seen from the schematic diagram of FIG. 2, the structural characteristics of the eutectic make a resistivity of the eutectic lower, which is conducive to further improving the carrier transport capacity. Thirdly, materials of the second conductive region 1b include the glass frit 14 and the metal particles 15. As can be seen from FIG. 2, although the glass frit 14 contacts the first semiconductor layer 201, it does not cause corrosion to the first semiconductor layer 201. The carrier transport of the first conductive region 1a depends on the structure of the hole 11, but the structure of the hole 11 inevitably destroys the structure of the contact interface 13 between the first metal electrode and the first semiconductor layer in a small region.

From the above analysis, it can be seen that the first conductive region 1a has excellent carrier transport capability but causes small region damage to the contact interface, and the second conductive region 1b has a carrier transport capability significantly weaker than that of the first conductive region 1a, but does not cause damage to the contact interface. Therefore, through the complementary cooperation of the first conductive region 1a and the second conductive region 1b, the excellent carrier transport capability can be more fully exerted, and the structural damage to the contact interface can be greatly reduced, so that the structural integrity of the contact interface is higher and the damage is less. Therefore, the contact performance of the metal-semiconductor contact structure 1 can be improved through the improvement of these two aspects, which is finally reflected in a certain improvement of electrical performance indexes such as photoelectric conversion efficiency of the solar cell.

Further, part of the metal particles 15 of the second conductive region 1b are also in contact with the conductive crystal 122 of the first conductive region 1a.

In an alternative implementation, the first conductive region 1a has only the conductive crystal 122 in the hole 11. In such a structure, carrier transport in the hole 11 is realized by the conductive crystal 122 having a higher purity, so that the metal-semiconductor contact structure 1 has more excellent carrier transport performance. In another alternative implementation, the hole 11 of the first conductive region 1a includes a glass frit 14 in addition to the conductive crystal 122, and a volume ratio of the conductive crystal 122 in the hole 11 is larger than a volume ratio of the glass frit 14 in the hole 11, that is, the conductive crystal 122 is a main component, and the glass frit 14 is a minor component. Compared with the structural characteristics that the metal particles 15 in the second conductive region 1b are surrounded by glass frit 14 and there are no holes 11, although a small amount of glass frit 14 remains in the holes 11 of the first conductive region 1a, since the conductive crystal 122 is still the main component in the hole 11, and is less affected by the glass frit 14 with higher resistivity, and the carrier transport capacity of the first conductive region 1a is much better than that of the second conductive region 1b.

The preparation method of the metal-semiconductor contact structure 1 described above will be further described below.

The preparation method of the metal-semiconductor contact structure 1 includes the following steps:
printing an electrode paste on the first semiconductor layer 201; the electrode paste including a glass frit 14, metal particles 15, and an organic carrier; wherein, the metal particles 15 include nano-silver particles, and a content of aluminum impurity element therein is less than 0.1 wt%, for example, a commercially available DK-93T type electrode paste can be employed;
low-temperature sintering the electrode paste to form an electrode precursor on the first semiconductor layer 201, the electrode precursor including a glass frit 14 and metal particles 15 wrapped in the glass frit; a temperature range of the low-temperature sintering is less than a peak sintering temperature of the electrode paste;
applying a reverse bias voltage to the electrode precursor and simultaneously performing laser-induced contact treatment to form the first metal electrode301, and forming the hole 11 and the conductive structure 12 in a contact interface 13 between the first metal electrode and the first semiconductor layer.

Wherein, the peak sintering temperature of the electrode paste refers to a sintering temperature range in which a glass frit phase in the electrode paste can ablate a passivation layer film and make the metal particles in the electrode paste have a lower resistivity after the sintering treatment, which is usually defined as the peak sintering temperature of the electrode paste by those skilled in the art. At the peak sintering temperature, the electrode paste will cause large area corrosion to the contact interface between the semiconductor layer and the metal electrode after ablating the passivation layer on the semiconductor layer. In the present application, the sintering temperature is controlled below the peak sintering temperature range to avoid occurrence of large-area corrosion on the contact interface, and at the same time reduce an adverse thermal influence on the solar cell when the high sintering temperature is used. As for the influence on the conductivity of the metal-semiconductor contact structure due to a decrease of the sintering temperature, the conductivity of the metal-semiconductor contact structure is improved by an operation of subsequently applying a reverse bias voltage and performing a laser-induced contact treatment. It can be seen that by combining the three technical means of reducing the peak sintering temperature of the electrode paste, applying reverse bias voltage and laser-induced contact treatment, the problem of large-area corrosion of the contact interface can be avoided, and the conductivity of the metal-semiconductor contact structure can be improved.

In preparing the metal-semiconductor contact structure 1, according to the preparation method of the embodiment of the present application, the electrode paste is firstly printed and low-temperature sintered so that the electrode paste is fixed on the first semiconductor layer 201, wherein the electrode paste includes the glass frit 14 and the metal particles 15 to form an electrode precursor including the glass frit 14 and the metal particles 15 wrapped in the glass frit 14. In the process of low-temperature sintering the electrode paste, at the temperature of the low-temperature sintering, the organic carrier in the electrode may be decomposed after the electrode paste is printed, and the electrode precursor including the metal particles 15 and the glass frit 14 wrapping the metal particles 15 is fixed onto the first semiconductor layer 201. Since the sintering temperature is lower than the peak sintering temperature of the electrode paste, the glass frit 14 is softened only to some extent, but does not achieve the effect of ablating the passivation film on the first semiconductor layer 201 in contact with the glass frit 14. Therefore, under the low sintering temperature condition, the glass frit 14 contacts the first semiconductor layer 201 but does not ablate the passivation layer on the first semiconductor layer 201. It can be seen that since the main purpose of the step of low-temperature sintering the electrode paste is to decompose the organic carrier component in the electrode paste, this step does not cause large-area corrosion damage to the surface of the first semiconductor layer 201.

On the basis of ensuring the integrity of the surface structure of the first semiconductor layer 201, the preparation method according to the embodiment of the present application further applies a reverse bias voltage to the electrode precursor and performs laser-induced contact treatment. On the one hand, the reverse bias voltage is used to further enhance a built-in electric field of the solar cell at the contact interface between the first semiconductor layer 201 and the electrode precursor. On the other hand, a large number of photogenerated carriers (i.e. electron-hole pairs) are generated by laser-induced contact treatment. Through the joint action of these two aspects, electron carriers and hole carriers are sorted by the electric field, and carriers of one charge electricity are rapidly transported to the first semiconductor layer 201 under the acceleration of the electric field (for example, when the first semiconductor layer 201 has a textured surface structure of a pyramid shape, the carriers are more easily transported to the spire and a position near the spire). These carriers generate a large amount of heat when passing through the glass frit 14 having a high resistivity, which decomposes the glass frit 14 at a position where the first semiconductor layer 201 has a strong conductivity to form the hole 11, and metal atoms, after melting the metal particles 15 at this position, diffuse into the semiconductor atomic lattice of the first semiconductor layer 201, and the conductive eutectic 121 of crystallization of the metal element and the semiconductor element growing together is formed in the vicinity of the position of the first semiconductor layer 201 corresponding to the hole 11. After the laser-induced contact treatment condition is withdrawn, the temperature of the metal-semiconductor contact structure region decreases, metal atoms are continuously precipitated from a common crystal composed of the metal element and the semiconductor element, and the conductive eutectic 121 at the contact interface is used as a nucleation point for crystallization growth to form the conductive crystal 122 located in the hole 11, and the aforementioned metal-semiconductor contact structure 1 is formed. Further, during the process of crystallization and aggregation of the conductive crystal 122 toward the inside of the hole 11, a crystal main chain 1221 may grow through crystallization and a crystal side chain 1222 may also grow in a side direction of the crystal main chain 1221 different from a growth direction of the crystal main chain 1221, and the crystal main chain 1221 and the crystal side chain 1222 have the characteristics of random distribution.

Among them, since the photogenerated carriers generated by the laser-induced contact treatment are transported to a local position on the first semiconductor layer 201 under an action of an electric field to generate a large amount of heat, the hole 11, the conductive structure 12 including the conductive eutectic 121 and the conductive crystal 122 are mainly distributed in a region corresponding to a region having strong conductivity on the first semiconductor layer 201 to form the first conductive region 1a. However, in a region outside the first conductive region 1a, the hole 11 and the conductive structure 12 are not formed because there is no large amount of heat generated by a large amount of carriers passing through the glass frit 14, and this region mainly includes the glass frit 14 and the metal particles 15, and the carrier transport is realized by contacting part of the metal particles 15 with the first semiconductor layer 201 to form the second conductive region 1b.

As can be seen from the above, in the above preparation method, since the glass frit 14 does not corrode the surface of the first semiconductor layer 201 in a large area in the step of curing the electrode paste, only the portion of the glass frit 14 in the first conductive region 1a is sintered to form the hole 11 in the step of applying the reverse bias voltage and the laser-induced contact treatment, and the glass frit 14 in the second conductive region 1b is not further heated and sintered. Therefore, the above method can form a metal-semiconductor contact structure 1 with the hole 11 and the conductive structure 12, while avoiding the problem of large-area corrosion damage to the first semiconductor layer 201 caused by high-temperature sintering of the glass material 14. This results in the metal-semiconductor contact structure 1 having excellent contact performance.

Further, in the step of low-temperature sintering the electrode paste, a low-temperature (peak) sintering temperature is 500°C to 650°C. Compared to the method of using a high-temperature peak sintering temperature of 750°C to 850°C after printing, which causes large-area corrosion of the first semiconductor layer by the glass frit, the embodiment of the present application adopts a low-temperature sintering process with an opposite technical approach. The purpose is to decompose the organic carrier in the electrode paste and weaken an etching ability of the glass frit 14 on the passivation layer on the first semiconductor layer 201, ensuring that after curing, the electrode precursor is merely fixed on the first semiconductor layer 201 without causing etching damage to the passivation layer on the first semiconductor layer 201. Exemplarily, in the step of curing the electrode paste, the heating temperature is 500 °C, 520 °C, 550 °C, 580 °C, 600 °C, 620 °C, or 650 °C.

Further, in the step of applying a reverse bias voltage to the electrode precursor and performing the laser-induced contact treatment, a voltage of the reverse bias voltage is 9V to 15 V The heat generated by the carriers generated by the laser-induced contact treatment when passing through the contact interface between the first semiconductor layer 201 and the electrode precursor is closely related to the aforementioned range of the reverse bias voltage. When the reverse bias voltage is within the aforementioned range, it is conducive to generating a higher heat of 1500K to 8000K as the carriers pass through the contact interface, and this higher heat is used to decompose the glass frit 14 at a corresponding position, thereby forming a region of the hole 11. Under the aforementioned reverse bias voltage conditions, all of the glass frit 14 in the region of the hole 11 will decompose or most of it will decompose. When the reverse bias voltage is at a lower voltage value within the aforementioned range, most of the glass frit 14 in the hole 11 will decompose, with a small portion remaining. Since conductive crystals 122 will still grow in the hole 11 and the volume ratio of the glass frit 14 is reduced, the carrier transport capability of the first conductive region 1a may still be enhanced by a combination affect of the hole 11 and the conductive structure 12. For example, the reverse bias voltage is 9 V, 10 V, 11 V, 12 V, 13 V, 14 V, or 15 V

Preferably, in the step of applying a reverse bias voltage to the electrode precursor and performing the laser-induced contact treatment, the voltage of the reverse bias voltage is 11 V Under the preferred reverse bias voltage conditions mentioned above, high temperatures of 3000K to 5000K can be generated at the contact interface. This instantaneous high temperature not only causes the glass frit 14 to decompose, leaving only the conductive crystal 122 or mostly conductive crystal 122 in the hole 11, but also melts the metal particles 15 and semiconductor atoms at the contact interface. Thereby, the molten semiconductor atoms can accommodate more metal atoms, increasing a proportion of metal atoms in the semiconductor material, reducing the resistivity of the conductive eutectic 121, and enhancing the carrier transport capability of the conductive eutectic 121.

Further, in the step of applying a reverse bias voltage to the electrode precursor and performing the laser-induced contact treatment, conditions of the laser-induced contact treatment include a single wavelength spectrum having a wavelength of 500 nm to 1100 nm, a current density of 1000A/cm² to 1400A/cm², and a scanning rate of 35 m/s to 55 m/s.

For the aforementioned laser-induced contact treatment conditions, a laser of a single wavelength is used to excite photogenerated carriers in the first semiconductor layer 201. Exemplarily, the wavelength of the injected laser light in the process of the laser-induced contact treatment is 532 nm, 635 nm, 650 nm, 808 nm, 980 nm, or 1064 nm. When the semiconductor element of the first semiconductor layer 201 is silicon and a laser is used for laser-induced contact treatment, it is preferable to use a laser with a wavelength of 1064 nm or 808 nm. When selecting the laser with the wavelength of 1064 nm or 808 nm, the photon energy of these wavelengths is just enough for the carriers to excite electron-hole pairs from the silicon substrate (a bandgap of silicon at room temperature of 300K is 1.12 eV), without imparting additional energy to the photogenerated carriers that would cause heating of the silicon lattice, thus avoiding any impact on the carrier transport capability.

Preferably, the preparation method of the metal-semiconductor contact structure 1 further includes a step of light injection:
In one implementation, light injection is performed after the step of low-temperature sintering the electrode paste and before the step of applying a reverse bias voltage to the electrode precursor and simultaneously performing laser-induced contact treatment. In another implementation, the light injection is performed after the step of applying a reverse bias voltage to the electrode precursor and simultaneously performing laser-induced contact treatment.

Through the light injection and the heating operation of the light injection process, the hydrogen atoms can diffuse from the passivation film layer to a recombination centers with high defect state density to improve the passivation effect at the recombination centers, which is beneficial to further improve the open circuit voltage and filling factor of the solar cell with the metal-semiconductor contact structure, and further improve the photoelectric conversion efficiency.

In addition, compared with a method of performing the light injection after the step of applying the reverse bias voltage to the electrode precursor and performing the laser-induced contact treatment, a method of firstly low-temperature sintering the electrode paste, then performing light injection, and then applying the reverse bias voltage to the electrode precursor and performing the laser-induced contact treatment is more advantageous to optimize the performance of the solar cell. This is because the operation of light injection also has a certain amount of heat, and when light injection is performed before applying the reverse bias voltage to the electrode precursor and performing laser-induced contact treatment, it is possible to passivate grain boundaries and defect states.

Further, the step of light injection includes: primarily heating of the electrode precursor, wherein a peak temperature of the primary heating is between 200°C to 600°C; secondary heating of the electrode precursor and illumination, wherein a peak temperature of the secondary heating is 100°C to 300°C, an energy density of the illumination is 10 kW/m² to 100 kW/m², and the wavelength of the illumination is a continuous spectral band of 500 nm to 1100 nm. By controlling the heating conditions and the illumination conditions in the above-mentioned range in the light injection step, not only a good passivation effect may be achieved, but also the glass frit corroding the first semiconductor layer due to an excessively high heating temperature may be prevented. Note that in the light injection step of the embodiment of the present application, a continuous spectral band having a wavelength of 500 nm to 1100 nm is injected, which is different from the single-wavelength laser used in the laser-induced contact treatment step.

Other structural film layers of the solar cell of the embodiment of the present application are further described below.

Referring back to FIG. 1, in the solar cell of the embodiment of the present application, the silicon substrate 100 has an N-type conductivity or a P-type conductivity, for example, the silicon substrate 100 is an N-type silicon wafer. A light-receiving surface of the silicon substrate 100 has a textured surface structure such as a pyramid-shaped textured surface structure. By providing the textured surface structure, it is advantageous to reduce the reflectivity of the surface of the silicon substrate 100 and increase the refraction and scattering of light inside the silicon substrate 100.

On the light-receiving surface of the silicon substrate 100, the first semiconductor layer 201 may be a diffusion layer formed by diffusing and doping an N-type doping element or a P-type doping element into the silicon substrate 100, or may be a doped polysilicon layer or a doped amorphous silicon layer formed on the light-receiving surface of the silicon substrate 100 by deposition. For example, the first semiconductor layer 201 of the silicon substrate may be a phosphorus diffusion layer or a boron diffusion layer, so that a PN junction is formed between an N-type silicon wafer and the first semiconductor layer 201, and when the silicon substrate 100 has a textured surface structure, it means that the surface of the first semiconductor layer 201 also has the same textured surface structure.

With regard to the first semiconductor layer 201 having a textured surface structure as described above, the textured surface structure is a pyramid structure, and the holes 11 in the metal-semiconductor contact structure 1 are located at one or more of a tip, a tower side or a tower bottom of the pyramid structure. That is, the holes 11 may be located at the tips of the pyramid structures or may be located at the sides of the pyramids. In general, when a thickness of the PN junction from a normal direction of a light-receiving surface of the solar cell is less than a thickness range of 2 microns, since doping atoms are preferentially implanted into the silicon substrate near the pyramid tip when preparing the PN junction, or the plasma used for depositing the passivation layer moves toward the PN junction at a certain movement rate, it is possible to preferentially reduce the thickness of the passivation film layer near the pyramid tip due to the impact of the plasma near the pyramid tip, or the silicon wafer with a pyramid textured surface structure is scratched during the flow of the production line process, and the probability of wearing off the pyramid tip is higher and the pyramid tip is damaged. The above-mentioned three possible causes result in a decrease in the thickness of the dielectric passivation layer at the pyramid tip and a position near the pyramid tip, while the resistivity of the passivation layer is usually high; therefore, the conductivity of the pyramid tip and a position near the pyramid tip is relatively high, and under the combined effects of the reverse bias voltage and the laser-induced contact treatment, these positions become a preferred transport path for photogenerated carriers. Here, the pyramid tip and the positions near the pyramid tip refer to a range extending outward by 2 micrometers along a direction parallel to the silicon substrate with the pyramid tip as a center point.

A first passivation layer 401 is further provided on a side of the first semiconductor layer 201 facing away from the silicon substrate 100. The first passivation layer 401 includes a composite layer of one or more of an aluminum oxide layer, a silicon oxide layer, a silicon nitride layer, and a silicon oxynitride layer. In the solar cell shown in FIG. 1, the first passivation layer 401 includes an alumina passivation layer 4011 disposed close to the first semiconductor layer 201 and an anti-reflection layer 4012 having an anti-reflection function disposed away from the first semiconductor layer 201. The first metal electrode 301 is in contact with the first semiconductor layer 201 after penetrating the anti-reflection layer 4012 and the aluminum oxide passivation layer 4011 in sequence.

Structural film layers of the light-receiving surface of the solar cell is described above. It will be appreciated that, depending on structural characteristics of different types of solar cells, layers of other structural characteristics may also be provided on the light-receiving surface and the backlight surface of the solar cell. The aforementioned metal-semiconductor contact structure 1 can also be used, for example, when the film layer of the backlight surface has the second metal electrode 302 and the first semiconductor layer 201 in contact with each other. In addition, the method of forming the structural film layer may also employ conventional practices of the prior art. For example, a silicon substrate 100 having a textured surface structure is obtained by texturing, a first semiconductor layer 201 having a PN junction is obtained by doping a doping element by means of thermal diffusion doping, a first passivation layer 401 is obtained by an ALD or PECVD process, etc. In addition, the embodiments of the present application can also use conventional practices such as polishing and cleaning according to the formation of a coating layer, a borosilicate glass layer or a phosphosilicate glass layer during the formation of each structural film layer, and this is not limited in the present application.

Taking an TOPCON solar cell shown in FIG. 1 as an example, in a direction away from the silicon substrate 100, a tunneling passivation layer 500, a second semiconductor layer 202, a second passivation layer 402 and a patterned second metal electrode 302 are successively provided on the backlight surface of the silicon substrate 100, and the second metal electrode 302 penetrates the second passivation layer 402 and then contacts the second semiconductor layer 202.

A material of the tunneling passivation layer 500 may include a plurality of dielectric materials, such as at least one of silicon oxide, amorphous silicon, polysilicon, and silicon carbide. Specifically, the tunneling passivation layer 500 may be composed of a silicon oxide layer containing silicon oxide. This is because the silicon oxide layer has excellent passivation properties, can minimize recombination loss of minority carriers at the surface of the semiconductor substrate, and is a thin film having excellent durability to a subsequent high-temperature process. The tunneling passivation layer 500 acts as a barrier for electrons or holes and may combine with the polysilicon layer to prevent minority carriers from passing through. The tunneling passivation layer 500 may also function as a pinhole channel to allow carriers within the solar cell to move freely, Selective passage of majority carriers through heavily doped polysilicon may be beneficial in reducing recombination loss of minority carriers. The second semiconductor layer 202 is a phosphorus-doped polysilicon layer, and the second passivation layer 402 is a passivation layer, and the material thereof can be any one material or any combination of materials selected from silicon oxide, aluminium oxide, silicon carbide, silicon nitride or silicon oxynitride layers.

Referring to FIG. 4, FIG. 4 is a schematic structural diagram of a second solar cell according to an embodiment of the present application, the solar cell is a HJT solar cell and the solar cell includes:
a silicon substrate 100;
a first intrinsic layer 601, a first semiconductor layer 201, and a first transparent conductive layer 701 sequentially provided on a light-receiving surface of the silicon substrate 100;
wherein, the first metal electrode 301 and the first semiconductor layer 201 and the first transparent conductive layer 701 form a metal-semiconductor contact structure 1.

The silicon substrate 100 has an N-type conductivity or a P-type conductivity, for example, the silicon substrate 100 is an N-type crystalline silicon layer. A light-receiving surface of the silicon substrate 100 has a textured surface structure such as a pyramid-shaped textured surface structure. The first intrinsic layer 601 is one or more stacked intrinsic amorphous silicon layers and/or hydrogenated amorphous silicon layers. The first semiconductor layer 201 is an N-type doped silicon layer or a P-type doped silicon layer; the doped silicon layer can be one layer or multiple layers; and the doped silicon layer can be a doped amorphous silicon layer or a doped microcrystalline silicon layer. The first transparent conductive layer 701 is one or more of an indium tin oxide layer, an aluminum-doped zinc oxide layer, a zinc oxide layer, an indium oxide layer, and a tin oxide layer.

In an alternative implementation, the silicon substrate 100 is an N-type crystalline silicon layer, the first semiconductor layer 201 is a P-type doped microcrystalline silicon layer, the first transparent conductive layer 701 is an indium tin oxide layer, and the first metal electrode 301 is a silver electrode.

During the preparation of the metal-semiconductor contact structure 1, the reverse bias voltage and the laser-induced contact treatment instantaneously generate local heat concentration points, and a large amount of heat instantaneously melts metal silver particles in the P-doped microcrystalline silicon layer, the first transparent conductive layer 701 and the electrode paste, so that part of the silver atoms successively diffuse into the first transparent conductive layer 701 and the P-doped microcrystalline silicon thin film, and forms the metal-semiconductor contact structure 1 composed of doped silicon, indium tin oxide and silver elements in a subsequent cooling process.

It will be appreciated that the backlight surface of the silicon substrate 100 may have structural film layers symmetrical to the light-receiving surface, i.e: a second intrinsic layer 602, a second semiconductor layer 202 and a second transparent conductive layer 702 are successively provided on the backlight surface of the silicon substrate 100, and a second metal electrode 302 is formed on the backlight surface, and the second metal electrode 302, the second semiconductor layer 202 and the second transparent conductive layer 702 form a metal-semiconductor contact structure 1.

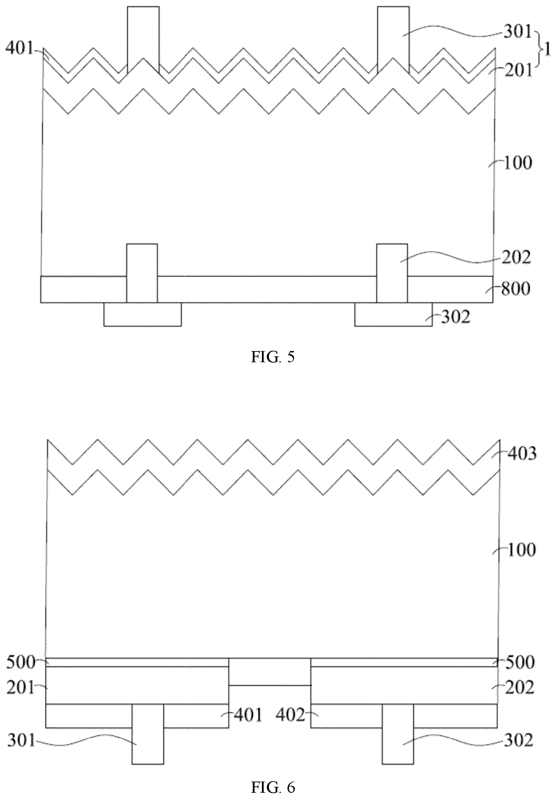

Referring to FIG. 5, FIG. 5 is a schematic structural diagram of a third solar cell according to an embodiment of the present application, the solar cell is a PERC solar cell and the solar cell includes:
a silicon substrate 100;
a first semiconductor layer 201 and a first passivation layer 401 sequentially formed on a light-receiving surface of the silicon substrate 100;
a first metal electrode 301 penetrating the first passivation layer 401 to form an ohmic contact with the first semiconductor layer 201;
wherein, the first metal electrode 301 and the first semiconductor layer 201 form a metal-semiconductor contact structure 1.

The silicon substrate 100 has an N-type conductivity or a P-type conductivity, for example, the silicon substrate 100 is a P-type silicon substrate 100. A light-receiving surface of the silicon substrate 100 has a textured surface structure such as a pyramid-shaped textured surface structure. By providing the textured surface structure, it is advantageous to reduce the reflectivity of the surface of the silicon substrate 100 and increase the refraction and scattering of light inside the silicon substrate 100. The first semiconductor layer 201 is an N-type doped silicon layer or a P-type doped silicon layer; the doped silicon layer can be one layer or multiple layers. In an alternative implementation, the silicon substrate 100 is a P-type crystalline silicon layer, the first semiconductor layer 201 is an N-type doped crystalline silicon layer, and the metal electrode 301 is a silver electrode.

It will be appreciated that the backlight surface of the silicon substrate 100 may have other structural layers corresponding to structural features of the PERC cell. For example, a back surface field passivation layer 800 with negative charge electricity is provided on the backlight surface of the silicon substrate 100. The second metal electrode 302 on the backlight surface is located on the side of the back surface field passivation layer 800 that is away from the silicon substrate 100, and the second metal electrode 302 is ohmically contacted with the second semiconductor layer 202.

Referring to FIG. 6, FIG. 6 is a schematic structural diagram of a fourth solar cell according to an embodiment of the present application, the solar cell is an IBC solar cell and the solar cell includes:
a silicon substrate 100;
a tunneling passivation layer 500, a first semiconductor layer 201 and a first passivation layer 401 which are successively provided in an N-type conductive region of a backlight surface of the silicon substrate 100, and a tunneling passivation layer 500, a second semiconductor layer 202 and a second passivation layer 402 which are successively provided in a P-type conductive region of the backlight surface of the silicon substrate 100, wherein the first semiconductor layer 201 has an N-type doping element, and the second semiconductor layer 202 has a P-type doping element;
a first metal electrode 301 penetrating the first passivation layer 401 of the N-type conductive region and ohmically contacted with the first semiconductor layer 201, so that the first metal electrode 301 and the first semiconductor layer 201 form a first metal-semiconductor contact structure 1;
a second metal electrode 302 penetrating the second passivation layer 402 of the P-type conductive region and ohmically contacted with the second semiconductor layer 202, so that the second metal electrode 302 and the second semiconductor layer 202 form a second metal-semiconductor contact structure 1.

The silicon substrate 100 has an N-type conductivity or a P-type conductivity, for example, the silicon substrate 100 is a P-type silicon substrate 100. A light-receiving surface of the silicon substrate 100 has a textured surface structure such as a pyramid-shaped textured surface structure. By providing the textured surface structure, it is advantageous to reduce the reflectivity of the surface of the silicon substrate 100 and increase the refraction and scattering of light inside the silicon substrate 100. In addition, other structural film layers may be provided on the light-receiving surface of the silicon substrate 100 according to actual needs. For example, a third passivation layer 403 is provided on the light-receiving surface of the silicon substrate 100.

The embodiments of the present application further provides a fifth solar cell (not shown in the FIGS.), which is a perovskite-crystalline silicon laminated solar cell, wherein the perovskite cell serves as a top cell, any one of the above-mentioned first solar cell to fourth solar cell serves as a bottom cell, and only needs to provide the metal-semiconductor contact structure having a hole and a conductive structure on a backlight surface of a crystalline silicon bottom cell.

In a second aspect, the present application provides a photovoltaic module including the solar cell according the first aspect. The photovoltaic module is formed by connecting several of the above solar cells in series and/or in parallel and packaging.

The metal-semiconductor contact structure, the preparation method thereof, the solar cell, and the photovoltaic module of the present application will be further described below with reference to more specific examples. In addition, the sodium hydroxide and TS40 additives, the electrode paste, etc. used in the following embodiments are commercially available, for example, the electrode paste has an Al content of 0.05 % to 0.50% and an oxygen content of 1.0% to 5.0%.

### Embodiment 1

This embodiment provides a solar cell having a metal-semiconductor contact structure, and the preparation therefor is as follows:
(1) Texturing: in a tank device, sodium hydroxide with a volume ratio of 7: 1 and an additive of type TS40 were used, the temperature was maintained at 80°C for 7min, rapid texturing was performed on a silicon substrate, and a thinning amount was controlled at 5 µm of the silicon substrate;
(2) Boron diffusion: the textured silicon substrate was placed into a boron diffusion furnace and BCl₃ was introduced at a temperature of 850°C to 1050°C for boron diffusion to form a boron diffusion layer;
(3) Alkaline etching: a chain-type HF device was used to remove the boron silicon glass on the backlight surface of the silicon substrate caused by boron diffusion, and then a tank-type alkaline etching machine was used to remove a P-N junction on the backlight surface and edges of the silicon substrate.
(4) Preparation of a tunneling passivation layer: a silicon oxide tunneling passivation layer was deposited on the backlight surface of the silicon substrate using a tube-type PECVD equipment.
(5) Preparation of a phosphorus-doped amorphous silicon Layer: a phosphorus-doped polycrystalline silicon layer was deposited on the tunneling passivation layer using a tube-type PECVD equipment.
(6) Annealing: a tube-type annealing furnace was used for performing annealing.
(7) RCA cleaning: firstly, the phosphorus-doped polycrystalline silicon layer and its mask layer that have been plated onto the light-receiving surface was removed by using hydrofluoric acid with a mass concentration of 5% while passing through a chain-type device, then the plated layer on the light-receiving surface was removed after transferred to a tank-type alkaline etching machine.
(8) Deposition of a passivation layer: an ALD device was used to deposit an aluminum oxide layer on the boron diffusion layer as the first passivation layer, then a PECVD device was used to deposit a silicon nitride oxide layer on the aluminum oxide layer as an anti-reflection layer; a PECVD device was used to deposit a silicon nitride oxide layer on the phosphorus-doped polycrystalline silicon layer as the second passivation layer; wherein the first passivation layer, the anti-reflection layer and the second passivation layer can all be understood as a passivation layer provided on the semiconductor layer;
(9) Fabrication of metal-semiconductor contact structures:
   (9. 1) the electrode paste was screen-printed on the anti-reflection layer and the second passivation layer, respectively;
   (9. 2) Low-temperature sintering electrode paste: the electrode paste was low-temperature sintered at a sintering temperature of 600°C to form an electrode precursor;
   (9. 3) Light injection: the electrode precursor was heated at a peak temperature of a primarily heating of 500°C, the electrode precursor was heated at a peak temperature of the secondary heating of 200°C, and light injection was performed using a continuous spectral band with a wavelength of 500 nm to 1100 nm under an energy density of light of 50 kW/m²;
   (9. 4) after the light injection, a reverse bias voltage was applied to the electrode precursor and a laser-induced contact treatment was performed, so that the electrode precursor located on the light-receiving surface and the backlight surface was converted into a first metal electrode and a second metal electrode, and the first metal electrode was in contact with the boron diffusion layer after penetrating the anti-reflection layer and the first passivation layer to form a first metal-semiconductor contact structure, and the second metal electrode was in contact with the phosphorus-doped polycrystalline silicon layer after penetrating the second passivation layer to form a second metal-semiconductor contact structure; wherein the reverse bias voltage is 15V, and the laser-induced contact treatment conditions include: a laser wavelength was 1064nm, a current density was 1200A/cm² and a scan rate was 40m/s.

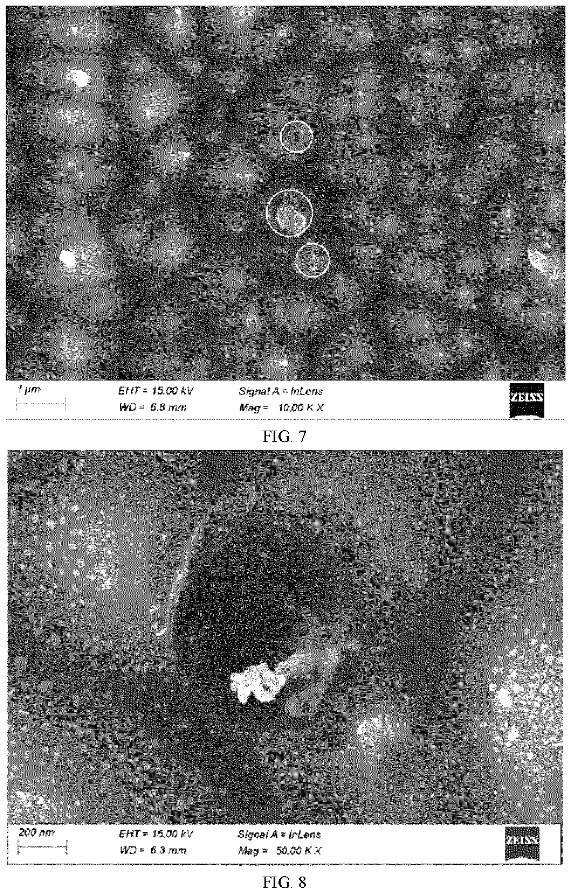

Scanning electron micrographs of the metal-semiconductor contact structure in the solar cell of this example were taken at different times to obtain SEM diagrams as shown in FIG. 7 and FIG. 8. FIG. 7 is a SEM diagram of a contact interface of the metal-semiconductor contact structure at a multiple of 10K and FIG. 8 is a SEM diagram of a contact interface of the metal-semiconductor contact structure at a multiple of 50K. It can be seen from FIG. 7 that the positions marked by circles in FIG. 7 are holes formed at the contact interface, and apart from the holes, the pyramid structures in other regions has a high degree of integrity and have not been subject to large-area corrosion. It can be further confirmed in conjunction with FIG. 8 that holes are formed at the contact interface, and conductive crystals exist in the holes, and correspondingly, there are conductive eutectic below the holes. It can be seen therefrom that in the present embodiment, in the metal-semiconductor contact structure, only the holes located in the first conductive region may cause a small region damage to the structure of the contact interface; the glass frit and the metal particles in the second conductive region do not cause a large area corrosion of the passivation layer on the pyramid structure of the contact interface; the pyramid structure can still maintain a high integrity, and the tower tip is not significantly damaged, thereby improving the contact performance of the metal-semiconductor contact structure.

### Embodiment 2

This embodiment differs from Embodiment 1 in that: in the step of Fabrication of metal-semiconductor contact structures, after low-temperature sintering the electrode paste, firstly a reverse bias voltage was applied and a laser-induced contact treatment was performed, then light injection was performed.

### Embodiment 3

This embodiment differs from Embodiment 1 in that: in the step of Fabrication of metal-semiconductor contact structures, light injection was not performed.

### Description of performance testing:

### Scanning Electron Microscope (SEM) testing:

By means of chemical etching, firstly, nitric acid was used to etch away the bulk silver of the metal electrode at an outermost layer of the solar cell, so as to expose the glass frit component used for burning through the passivation layer, and then hydrofluoric acid was used to etch away the glass frit component layer, so as to expose the holes located at the contact interface of the metal-semiconductor contact structure, which is photographed by a scanning electron microscope, and a corresponding SEM diagram was obtained.

### Hole density, hole diameter and conductive crystal size test:

According to a quantity and a region of the hole in a specified range in the SEM diagram, the density of holes was calculated.

The hole diameter of the holes was measured according to a SEM diagram.

The size of the conductive crystals was measured according to the SEM diagram.

The technical solution disclosed in the embodiments of the present application are described in detail above. Specific examples are used herein to illustrate the principle and implementations of the present application. The descriptions of the above embodiments are only used to help understand the technical solution of the present application and core ideas thereof. Moreover, for those of ordinary skill in the art, according to the ideas of the present application, there will be changes in the specific implementations and the scope of application. In summary, the content of this specification should not be construed as limiting the present application.

## Claims

1. A metal-semiconductor contact structure, wherein the metal-semiconductor contact structure comprises a metal electrode and a semiconductor layer in contact with each other, the metal electrode has a metal element, the semiconductor layer has a semiconductor element and a doping element for doping the semiconductor layer;
a contact interface between the metal electrode and the semiconductor layer has a hole and a conductive structure, the conductive structure comprises a conductive eutectic adjacent to the semiconductor layer, and a conductive crystal extending from the conductive eutectic into the hole, the conductive eutectic comprises a eutectic formed by the metal element and the semiconductor element, the conductive crystal comprises a crystal formed by crystallization of the metal element.

2. The metal-semiconductor contact structure according to claim 1, wherein the metal-semiconductor contact structure has a first conductive region and a second conductive region outside the first conductive region, the first conductive region has the hole and the conductive structure, the second conductive region has a glass frit and metal particles, the glass frit is in contact with the semiconductor layer and ablate a portion of a passivation layer on the semiconductor layer;
wherein the metal particles form a direct conductive contact with the semiconductor layer through the portion of the passivation layer that is ablated;
the metal particles and the conductive crystal have a same kind of the metal element.

3. The metal-semiconductor contact structure according to claim 1, wherein:
a density of the hole is greater than or equal to 10/mm² and less than 100/mm;
a hole diameter of the hole is 100 nm to 2000 nm; and/or
a size of the conductive crystal is 10 nm to 100 nm.

4. The metal-semiconductor contact structure according to claim 1, wherein the metal electrode is a silver electrode and an aluminum impurity content of the silver electrode is less than 0.1wt%.

5. A preparation method of a metal-semiconductor contact structure, wherein the metal-semiconductor contact structure is the metal-semiconductor contact structure according to any one of claims 1 to 4, the production method comprising the steps of:
printing an electrode paste on the semiconductor layer; the electrode paste comprises a glass frit, metal particles, and an organic carrier;
low-temperature sintering the electrode paste to form an electrode precursor on the semiconductor layer, the electrode precursor comprising a glass frit and metal particles wrapped in the glass frit; a sintering temperature of the low-temperature sintering is less than a peak sintering temperature of the electrode paste;
applying a reverse bias voltage to the electrode precursor and simultaneously performing laser-induced contact treatment to form the metal electrode, and forming the hole and the conductive structure in a contact interface region between the metal electrode and the semiconductor layer.

6. The preparation method according to claim 5, wherein, in the step of low-temperature sintering the electrode paste, the sintering temperature is 500°C to 650°C;
and/or,
in the step of applying a reverse bias voltage to the electrode precursor and simultaneously performing the laser-induced contact treatment, a voltage of the reverse bias voltage is 9 V to 15 V;
and/or,
in the step of applying a reverse bias voltage to the electrode precursor and performing the laser-induced contact treatment, conditions of the laser-induced contact treatment comprise a single wavelength spectrum having a wavelength of 500 nm to 1100 nm, a current density of 1000A/cm2 to 1400A/cm², and a scanning rate of 35 m/s to 55 m/s.

7. The preparation method according to claim 5, wherein, the preparation method further comprises: performing light injection after the step of low-temperature sintering the electrode paste and before the step of applying a reverse bias voltage to the electrode precursor and simultaneously performing laser-induced contact treatment;
or, the preparation method further comprises: performing light injection after the step of applying a reverse bias voltage to the electrode precursor and simultaneously performing laser-induced contact treatment.

8. The preparation method according to claim 7, wherein, the step of light injection comprises:
primarily heating of the electrode precursor, wherein a peak temperature of the primary heating is 200°C to 600°C;
secondary heating of the electrode precursor and illumination, wherein a peak temperature of the secondary heating is 100°C to 300°C, an energy density of the illumination is 10kW/m² to 100 kW/m², and a wavelength of the illumination is a continuous spectral band of 500 nm to 1100 nm.

9. A solar cell, wherein the solar cell comprises the metal-semiconductor contact structure according to any one of claims 1 to 4.

10. The solar cell according to claim 9, wherein, the solar cell further comprises:
a silicon substrate having a light-receiving surface with a textured surface structure;
wherein the metal-semiconductor contact structure is provided on a light-receiving surface and/or a backlight surface of the silicon substrate, the semiconductor layer of the metal-semiconductor contact structure is provided close to the silicon substrate, and the semiconductor layer also has the textured surface structure.

11. The solar cell according to claim 9, wherein, the solar cell is a TOPC on cell and the solar cell comprises:
a silicon substrate;
a PN junction region, a first passivation layer, and a first metal electrode sequentially provided on a light-receiving surface of the silicon substrate in a direction away from the light-receiving surface, wherein the PN junction region is a first semiconductor layer;
a passivation contact structure, a second passivation layer and a second metal electrode sequentially provided on a backlight surface of the silicon substrate in a direction away from the backlight surface, wherein:
the passivation contact structure comprises a tunneling passivation layer provided close to the silicon substrate and a doped silicon layer provided away from the silicon substrate, the doped silicon layer has a same conductivity type as the silicon substrate, and the doped silicon layer is a second semiconductor layer;
the first metal electrode penetrates the first passivation layer into contact with the first semiconductor layer so that the PN junction region and the first metal electrode form the metal-semiconductor contact structure, and/or, the second metal electrode penetrates the second passivation layer into contact with the doped silicon layer so that the doped silicon layer and the second metal electrode form the metal-semiconductor contact structure;
wherein:
the first semiconductor layer is formed by performing thermal diffusion of the doping element to the silicon substrate, or the first semiconductor layer is a doped polysilicon layer or a doped amorphous silicon layer deposited on the light-receiving surface of the silicon substrate;
the first passivation layer is one or more of an aluminum oxide layer, a silicon oxide layer, a silicon oxynitride layer, and a silicon nitride layer deposited on the PN junction region;
the tunneling passivation layer is at least one of a silicon oxide layer, an amorphous silicon layer, a polycrystalline silicon layer, and a silicon carbide layer; and/or
the second passivation layer is one or more of a silicon oxide layer, a silicon oxynitride layer, and a silicon nitride layer deposited on the second semiconductor layer.

12. The solar cell according to claim 9, wherein, the solar cell is a HJT cell and the solar cell comprises:
a silicon substrate;
a first intrinsic layer, a first semiconductor layer, a first transparent conductive layer sequentially provided on a light-receiving surface of the silicon substrate, and a first metal electrode disposed on the light-receiving surface of the silicon substrate;
a second intrinsic layer, a second semiconductor layer, a second transparent conductive layer sequentially provided on a backlight surface of the silicon substrate, and a second metal electrode disposed on the backlight surface of the silicon substrate;
wherein the first metal electrode and the first semiconductor layer and the first transparent conductive layer forming the metal-semiconductor contact structure, and/or the second metal electrode and the second semiconductor layer and the second transparent conductive layer forming the metal-semiconductor contact structure;
wherein:
the first intrinsic layer comprises one or more of an intrinsic amorphous silicon layer, a hydrogenated amorphous silicon layer and a silicon oxide layer;
the first semiconductor layer is one or more doped silicon layers;
the first transparent conductive layer is one or more of an indium tin oxide layer, an aluminum-doped zinc oxide layer, a zinc oxide layer, an indium oxide layer, and a tin oxide layer;
the second intrinsic layer comprises one or more of an intrinsic amorphous silicon layer and a hydrogenated amorphous silicon layer;
the second semiconductor layer is one or more doped silicon layers; and/or
the second transparent conductive layer is one or more of an indium tin oxide layer, an aluminum-doped zinc oxide layer, a zinc oxide layer, an indium oxide layer, and a tin oxide layer.

13. The solar cell according to claim 9, wherein, the solar cell is a PERC cell and the solar cell comprises:
a silicon substrate;
a first semiconductor layer and a first passivation layer sequentially formed on a light-receiving surface of the silicon substrate;
a first metal electrode penetrating the first passivation layer and forming the metal-semiconductor contact structure with the first semiconductor layer;
wherein, the solar cell further comprises a second semiconductor layer and a backside field passivation layer sequentially provided on a backlight surface of the silicon substrate, and a second metal electrode is further provided on a side of the backlight surface of the silicon substrate, and the second metal electrode is in ohmic contact with the second semiconductor layer.

14. The solar cell according to claim 9, wherein, the solar cell is an IBC cell and the solar cell comprises:
a silicon substrate;
a tunneling passivation layer, a first semiconductor layer, a first passivation layer, and a first metal electrode sequentially provided on an N-type conductive region of a backlight surface of the silicon substrate;
the tunneling passivation layer, a second semiconductor layer, a second passivation layer, and a second metal electrode sequentially provided on a P-type conductive region of the backlight surface of the silicon substrate; one layer of the first semiconductor layer and the second semiconductor layer has an N-type doping element and the other layer has a P-type doping element;
wherein the first metal electrode penetrates the first passivation layer and contacts the first semiconductor layer, so that the first metal electrode and the first semiconductor layer form the metal-semiconductor contact structure, and/or, the second metal electrode penetrates the second passivation layer and contacts the second semiconductor layer, so that the second metal electrode and the second semiconductor layer form the metal-semiconductor contact structure.

15. A photovoltaic module, wherein the photovoltaic module comprises the solar cell according to any one of claims 9 to 14.
